Europäisches Patentamt

European Patent Office

Office européen des brevets

(19)

(11) Veröffentlichungsnummer: **0 236 525 B1**

(12) **EUROPÄISCHE PATENTSCHRIFT**

(45) Veröffentlichungstag der Patentschrift:
19.12.90

(51) Int. Cl.⁵: **H03K 5/13**

(21) Anmeldenummer: **86103301.7**

(22) Anmeldetag: **12.03.86**

(54) **Integrierte Isolierschicht-Feldeffekttransistor-Verzögerungsleitung für Digitalsignale.**

(43) Veröffentlichungstag der Anmeldung:
**16.09.87 Patentblatt 87/38**

(45) Bekanntmachung des Hinweises auf die Patenterteilung:
**19.12.90 Patentblatt 90/51**

(84) Benannte Vertragsstaaten:
**DE FR NL**

(56) Entgegenhaltungen:
**EP-A- 0 171 022**
**EP-A- 0 175 501**
**US-A- 4 260 959**
**US-A- 4 387 349**

**PATENTS ABSTRACTS OF JAPAN, Band 4,**
**Nr. 162 (E-33)[644], 12. November 1980; &**
**JP-A-55 111 158 (NIPPON PRECISION CIRCUITS**
**K.K.) 27-08-1980**
**PATENTS ABSTRACTS OF JAPAN, Band 8,**
**Nr. 161 (E-257)[1598] 26. Juli 1984; &**
**JP-A-59 61 312 (TOSHIBA K.K.) 07-04-1984**

(73) Patentinhaber: **Deutsche ITT Industries GmbH,**
**Hans-Bunte-Strasse 19 Postfach 840,**
**D-7800 Freiburg(DE)**

(72) Erfinder: **O'Leary, Paul, Schwarzwaldstrasse 24,**
**D-7803 Gundelfingen(DE)**

ACTORUM AG

**Beschreibung**

Die Erfindung betrifft eine integrierte Isolierschicht-Feldeffekttransistor-Verzögerungsleitung für Digitalsignale mit signalflußmäßig in Serie geschaltete Inverter. Das Prinzip einer derartigen Verzögerungsleitung ist in "Patent Abstracts of Japan", Bd. 8, Nr. 161 (E-257), Seite 1598, 26. Juli 1984 (betrifft JP-A-59/61 312) beschrieben. Dort ist als ein Teil einer Verzögerungsstufe die Serienschaltung eines gegenphasig anzusteuernden Schalterpaares gezeigt, deren außenliegende Schaltungsklemmen jeweils über eine Konstantstromquelle mit dem positiven bzw. negativen Versorgungspotential verbunden sind. Die beiden gegenphasig anzusteuernden Schalter dürften für die beiden in Reihe liegenden Transistoren eines CMOS Inverters stehen, vgl. den Oberbegriff des Patentanspruchs. Eine hierzu ähnliche Reihenschaltung von Konstantstromquelle, CMOS-Inverter und weiterer Konstantstromquelle ist beispielsweise auch in "Patent Abstracts of Japan", Bd. 4, Nr. 162 (E-33), Seite 644, 12. November 1980 (betrifft JP-A-55/11 158) beschrieben.

Aus EP-A2 0 171 022 ist eine integrierte Feldeffekttransistor-Verzögerungsleitung für Digitalsignale mit signalflußmäßig in Serie geschalteten Invertern, insbesondere aus der dortigen Fig. 4, im Prinzip bekannt. Die Verzögerungsanordnung wird hierbei für einen Ringoszillator aus hintereinandergeschalteten CMOS-Inverter verwendet, wobei die Verzögerungszeit und damit die Oszillatorfrequenz durch den Strom gesteuert wird, der die CMOS Inverter speist. Dies erfolgt für alle positiven bzw. negativen Anschlußpunkte gemeinsam über eine P- bzw. N-Kanal-Konstantstromquelle. Die Ausbildung der betreffenden N-Kanal- und P-Kanal-Transistoren als Bestandteile von Mehrfach-Stromspiegeln bei einem CMOS-Relaxationsoszillator mit einstellbarer Oszillatorfrequenz ist beispielsweise aus US-A 4 260 959 bekannt.

Aus EP-A 59 802 ist ebenfalls eine integrierte Isolierschicht-Feldeffekttransistor-Verzögerungsleitung für Digitalsignale bekannt, die signalflußmäßig in Serie geschaltete Inverter aufweist. Die Verzögerungszeit ist dadurch äquidistant stufenweise einstellbar gemacht, daß der Ausgang jedes zweiten Inverters über einen Eins-aus-n-Auswahl-Schalter abgegriffen werden kann.

Der durch den einzigen Anspruch gekennzeichneten Erfindung liegt die Aufgabe zugrunde, eine Verzögerungsleitung für gegenphasige Digitalsignale zu schaffen, deren Verzögerungszeit elektrisch kontinuierlich einstellbar ist und deren Verzögerungszeit in den beiden gegenphasigen Datenpfaden sehr gleichförmig ist.

Die vorbeschriebenen Anordnungen ermöglichen teilweise zwar eine kontinuierliche elektrische Einstellmöglichkeit der Verzögerungszeit über die Größe der von den Konstantstromquellen zugeführten Ströme. Für die geforderte Gleichförmigkeit der Verzögerung bei gegenphasigen Signalen geben sie jedoch keine Anregung.

Die Erfindung wird nun anhand der Figuren der Zeichnungen näher erläutert.

Fig. 1 zeigt die erste und die letzte Stufe einer bekannten Verzögerungsleitung mit Stromspiegeln, und

Fig. 2 zeigt ein Ausführungsbeispiel nach der Erfindung.

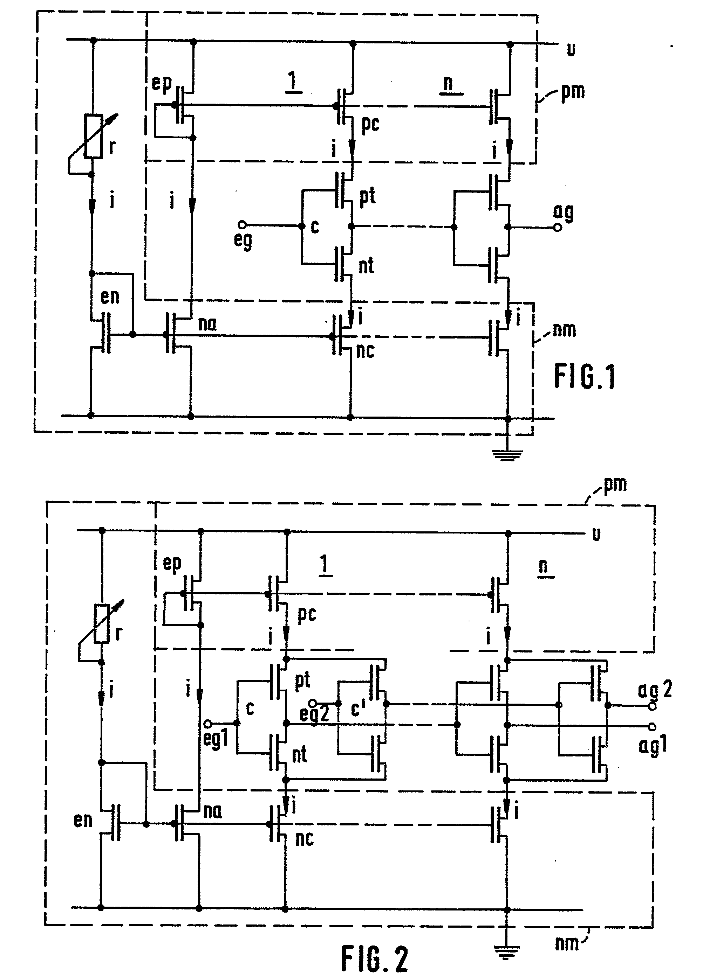

Im Ausführungsbeispiel der Fig.1 sind die erste Stufe 1 und die letzte Stufe n der Verzögerungsleitung gezeigt. Dabei sind die einzelnen Stufen untereinander gleich und wie folgt aufgebaut: Zu der den üblichen CMOS-Inverter c bildenden Serienschaltung der gesteuerten Strompfade des N-Kanal-Transistors nt und des P-Kanal-Transistors pt, deren miteinander verbundene Gates den Digitalsignal-Eingang eg und deren Strompfad-Verbindungspunkt der Digitalsignal-Ausgang ag ist, ist auf der Seite des N-Kanal-Transistors nt der N-Kanal-Konstantstrom-Transistor nc und auf der Seite des P-Kanal-Transistors pt der P-Kanal-Konstantstrom-Transistor pc zum jeweiligen Pol der Betriebsspannungsquelle u hin in Reihe geschaltet.

Ferner sind sämtliche N-Kanal-Konstantstrom-Transistoren Bestandteil des N-Kanal-Mehrfach-Stromspiegels nm und sämtliche P-Kanal-Konstantstrom-Transistoren Bestandteil des P-Kanal-Mehrfach-Stromspiegels pm. Sämtliche Transistoren der beiden Stromspiegel sind so dimensioniert, daß sie dem Betrag nach gleiche und zum einstellbaren Referenzstrom i gleiche Ströme führen können. Die Einstellbarkeit des Referenzstroms i ist im Ausführungsbeispiel der Fig.1 durch den einstellbaren Widerstand r symbolisiert, der an der Betriebsspannungsquelle u und am Eingangstransistor en des N-Stromspiegels mn angeschlossen ist. Der dem Eingangstransistor en eingeprägten Strom i kann jedoch auch auf andere Art und Weise als mittels eines Widerstandes erzeugt sein. So kann er beispielsweise die Steuergröße in einer phasenverriegelten Schleife sein. Der Eingangstransistor ep des P-Stromspiegels pm erhält seinen eigenen Referenzstrom i vom zusätzlichen P-Kanal-Konstantstrom-Transistor na des N-Stromspiegels eingeprägt.

Die Schaltung nützt die Eigenschaft des CMOS-Inverters aus, daß in Abhängigkeit vom am Eingang liegenden Binärsignalpegel H bzw. L entweder der P-Kanaltransistor pt leitend und der N-Kanaltransistor nt gesperrt bzw. der P-Kanaltransistor pt gesperrt und der N-Kanaltransistor nt leitend sind. Bei einem H/L- bzw. L/H-Signalwechsel wird nach Überschreiten der Gateschwellspannung des noch gesperrten und nunmehr gerade leitend werdenden Transistors die Eingangskapazität der am Ausgang angeschlossenen nächsten Stufe vom Strom i aufgeladen bzw. entladen. Diese Aufladung geschieht bekanntlich linear und mit einer Steilheit, die dem Strom i direkt proportional ist. Der Eingangssignalwechsel wird somit in Abhängigkeit vom Strom i pro Stufe verzögert an den Ausgang jeder Stufe durchgeschaltet.

Die Fig.2 zeigt die erfinderische Weiterbildung der Anordnung nach Fig.1. In jeder Stufe ist dem Strompfad des CMOS-Inverters c der Strompfad des weiteren CMOS-Inverters c' parallelgeschaltet. Dadurch hat jede Stufe die beiden Eingänge eg1 (zum CMOS-Inverter c gehörend) und eg2 (zum weiteren CMOS-Inverter c' gehörend) sowie zwei entsprechende Ausgänge. Innerhalb der Verzögerungsleitung sind gleichartige Eingänge und Ausgänge miteinander verbunden. Dadurch steht in einer Stufe sowohl das invertierte als auch das nichtinvertierte Eingangssignal zur Verfügung, das bei der Anordnung nach Fig.1 immer nur an einer übernächsten Stufe abgreifbar ist.

Bei der Verzögerungsleitung nach der Erfindung sind die Anstiegs- und Abfallflanken von Impulsen gut aneinander angepaßt. Ferner ist die Steuercharakteristik der Verzögerungsleitung unabhängig von Herstellprozeß-Parametern. Mittels der Weiterbildung nach Fig.2 läßt sich die Paar-Verzögerungszeit der beiden Inverter einer Stufe sehr niedrig, insbesondere kleiner als eine Nanosekunde einstellen, so daß die Verzögerungsleitung auch bei sehr hohen Signalfrequenzen angewendet werden kann. Dies gilt insbesondere, wenn zur Realisierung eine 1,5-Mikrometer-Technologie verwendet wird. Bei sorgfältiger Auslegung des Layouts der Verzögerungsleitung läßt sich die Schwankung der Verzögerunsgzeit der einzelnen Stufen kleiner als 1% halten.

Durch die bei der Erfindung verwendeten Stromspiegel ergibt sich ein großer Variationsbereich der Verzögerungszeit, z.B. um den Faktor 10. Auch das Rauschverhalten ist sehr gut, was durch die Eigenschaft der Stromspiegel bedingt ist. Die Anordnung der Erfindung rauscht wesentlich weniger als die eingangs erwähnte, vorbeschriebene Anordnung nach EP-A 0 059 802.

## Patentansprüche

Integrierte Isolierschicht-Feldeffekttransistor-Verzögerungsleitung für Digitalsignale mit signalflußmäßig in Serie geschalteten Invertern, wobei

    – die Inverter übliche, von der Serienschaltung der gesteuerten Strompfade eines N-Kanal-Transistors (nt) und eines P-Kanal-Transistors (pt) gebildete CMOS-Inverter (c) sind,

    – zu jedem CMOS-Inverter (c) auf der Seite des N-Kanal-Transistors (nt) ein N-Kanal-Konstantstrom-Transistor (nc) und auf· der Seite des P-Kanal-Transistors (pt) ein P-Kanal-Konstantstrom-Transistor (pc) zum jeweiligen Pol der Betriebsspannungsquelle (u) hin in· Reihe geschaltet ist und

    – der N- und der P-Kanal-Konstantstrom-Transistor (pc) so dimensioniert sind, daß sie dem Betrag nach gleiche Ströme führen können, gekennzeichnet durch folgende Merkmale:

    – sämtliche N-Kanal-Konstantstrom-Transistoren sind Bestandteil eines N-Kanal-Mehrfach-Stromspiegels (nm),

    – sämtliche P-Kanal-Konstantstrom-Transistoren sind Bestandteil eines P-Kanal-Mehrfach-Stromspiegels (pm),

    – sämtliche Transistoren der beiden Stromspiegel sind so dimensioniert, daß sie dem Betrag nach gleiche und zu einem einstellbaren Referenzstrom (i) gleiche Ströme führen können, und

    – in jeder Stufe (1, n) ist dem Strompfad des CMOS-Inverters (c) der Strompfad eines weiteres CMOS-Inverters (c') parallelgeschaltet und in jeder Stufe (1, n) ist der Ausgang des CMOS-Inverters bzw. des weiteren CMOS-Inverters mit dem Eingang des CMOS-Inverters der in Signalflußrichtung liegenden nächsten Stufe verbunden.

## Claims

Insulated-gate field-effect transistor integrated delay line for digital signals comprising cascaded inverters, wherein

    - the inverters are conventional CMOS inverters (c) formed by the series combination of the controlled current paths of an N-channel transistor (nt) and a P-channel transistor (pt),

    - each CMOS inverter (c) has an N-channel constant-current transistor (nc) on the side of the N-channel transistor (nt) and a P-channel constant-current transistor (pc) on the side of the P-channel transistor (pt) connected in series therewith which are coupled to the respective terminal of the supply-voltage source (u), and

    - the N-channel constant-current transistor and the P-channel constant-current transistor (pc) are designed to be capable of carrying currents which are equal in magnitude, characterized by the following features:

    - all N-channel constant-current transistors form part of an N-channel multiple current mirror (nm);

    - all P-channel constant-current transistors form part of a P-channel multiple current mirror (pm);

    - all transistors of the two current mirrors are designed to be capable of carrying currents which are equal in magnitude and equal to an adjustable reference current (i), and

    - in each stage (1, n), the current path of the CMOS inverter (c) is shunted by the current path of an additional CMOS inverter (c'), and in each stage (1, n), the output of the CMOS inverter and the output of the additional CMOS inverter are coupled, respectively, to the inputs of the CMOS inverter and the additional CMOS inverter of the next stage in the direction of current flow.

## Revendications

Ligne à retard intégrée à transistors à effet de champ et à couche isolante pour signaux numériques, comportant des inverseurs branchés en série dans le sens de transmission des signaux, et dans laquelle

    – les inverseurs sont des inverseurs CMOS (c) usuels, formés par le branchement en série des voies de courant commandées d'un transistor à canal N (nt) et d'un transistor à canal P (pt),

    – avec chaque inverseur CMOS (c) sont branchés en série, du côté du transistor à canal N (nt), un transistor à courant constant à canal N (nc) et, du côté du transistor à canal P (pt), un transistor à courant constant à canal P (pc), ces transistors étant raccordés aux pôles respectifs de la source de tension de service (u), et

– les transistors à courant constant à canal N et à canal P (pc) sont dimensionnés de manière qu'ils peuvent véhiculer des courants de même intensité, caractérisée par les caractéristiques suivantes:

– les transistors à courant constant à canal N font tous partie d'un miroir de courant multiple à canal N (nm),

– les transistors à courant constant à canal P font tous partie d'un miroir de courant multiple à canal P (pm),

– les transistors des deux miroirs de courant sont tous dimensionnés de manière qu'ils peuvent véhiculer des courants de même intensité et égaux à un courant de référence réglable (i), et

– dans chaque étage (1, n), en parallèle avec la voie de courant de l'inverseur CMOS (c) est branchée la voie de courant d'un autre inverseur CMOS (c') et, dans chaque étage (1, n), la sortie de l'inverseur CMOS ou de l'autre inverseur CMOS est reliée de l'étage immédiatement suivant dans la direction de transmission des signaux.

FIG.1

FIG. 2